Europäisches Patentamt

(19) European Patent Office

Office européen des brevets

(11) Numéro de publication: **0 010 022**
**A1**

## (12) DEMANDE DE BREVET EUROPEEN

(21) Numéro de dépôt: **79400655.1**

(22) Date de dépôt: **18.09.79**

(51) Int. Cl.³: **H 03 G 3/34**
**H 04 B 1/04**

(30) Priorité: **29.09.78 FR 7827922**

(43) Date de publication de la demande:
**16.04.80 Bulletin 80, 8**

(84) Etats-Contractants Désignés:
**BE CH DE GB IT NL SE**

(71) Demandeur: **"THOMSON-CSF"**
**173, boulevard Haussmann**
**F-75360 Paris Cedex 08(FR)**

(72) Inventeur: **Ben Sadou, Jean-Claude**
**Thomson-CSF - SCPI 173, bld Haussmann**
**F-75360 Paris Cedex 08(FR)**

(74) Mandataire: **Courtellemont, Alain et al,**
**"THOMSON-CSF" - SCPI 173, bld Haussmann**
**F-75360 Paris Cedex 08(FR)**

(54) **Dispositif de traitement des signaux vocaux et émetteur comprenant un tel dispositif.**

(57) La présente invention concerne des dispositifs de traitement des signaux vocaux de modulation.

Un dispositif de traitement délivre des signaux de parole d'amplitude constante pendant les périodes d'activité de parole et ne transmet rien (ne transmet pas de bruit) en dehors de ces périodes. Le dispositif de traitement comporte un dispositif de compression d'amplitude 4 précédé d'un détecteur d'activité vocale constitué d'une ligne à retard 1, d'un discriminateur parole-bruit 2, et d'un interrupteur électronique 3. Cet interrupteur 3 est commandé par le signal de sortie du discriminateur 2 de façon à ne laisser passer que les signaux de parole.

Application aux émetteurs de signaux vocaux.

EP 0 010 022 A1

1

# DISPOSITIF DE TRAITEMENT DES SIGNAUX VOCAUX
# ET ÉMETTEUR COMPORTANT UN TEL DISPOSITIF

La présente invention concerne les dispositifs de traitement des signaux vocaux d'un émetteur comportant des moyens de compression de leur amplitude.

Lors d'une transmission classique d'un signal de parole, le rapport entre la puissance crête et la puissance moyenne de la parole est de l'ordre de 15 dB ; ce fait a pour conséquence un mauvais bilan de transmission.

Pour y remédier, il est connu d'utiliser des dispositifs de compression de l'amplitude du signal de parole transmis.

Tous les dispositifs utilisés (boucle de compression, amplificateur saturé ...) amplifient fortement le bruit pendant les durées des silences de la parole émise, ce qui rend la réception très désagréable.

La présente invention a pour objet de remédier à cet inconvénient.

Selon l'invention, un dispositif de traitement de signaux vocaux comportant un dispositif de compression d'amplitude des signaux vocaux délivrant des signaux compressés en amplitude, est caractérisé en ce qu'il comporte des moyens de détection d'activité vocale pour interrompre la délivrance des signaux compressés en l'absence d'activité vocale dans les signaux vocaux.

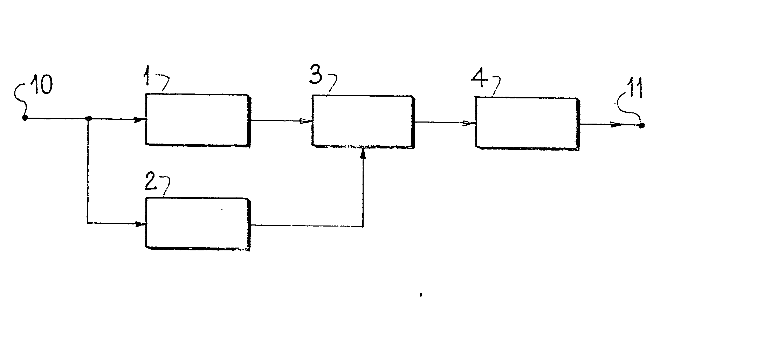

L'invention sera mieux comprise et d'autres caractéristiques apparaîtront à l'aide de la description ci-après et de la figure s'y rapportant qui représente un schéma d'un mode de réalisation du dispositif selon l'invention.

Sur cette figure une borne d'entrée 10, recevant le signal vocal, est reliée, en parallèle, à l'entrée d'une ligne à retard 1 et à l'entrée d'un discriminateur parole-bruit 2. Un interrupteur électronique 3 reçoit sur son entrée le signal de sortie de la ligne à retard 1 et est commandé par le signal de sortie du discriminateur 2. La ligne à retard 1, le discriminateur 2 et l'interrupteur électronique 3 constituent un détecteur d'activité vocale. Cet interrupteur électronique 3 est relié à la borne de sortie 11 du dispositif de traitement des signaux vocaux à travers un dispositif de compression d'amplitude 4.

Le fonctionnement de ce dispositif est le suivant.

Le discriminateur parole-bruit 2 délivre à sa sortie un signal qui ferme l'interrupteur électronique 3, lorsque le signal d'entrée, reçu sur la borne 10, est un signal de parole. Cependant comme la commande de l'interrupteur électronique 2 s'effectue avec un retard $T_1$ (temps nécessaire à l'élaboration de son signal de commande) par rapport au signal d'entrée (reçu sur la borne 10), la ligne à retard 1 doit présenter un retard égal à $T_1$ afin que l'interrupteur électronique 3 ne soit fermé que lorsqu'un signal de parole se présente à son entrée. Le signal de sortie de l'interrupteur électronique 3 est ensuite amplifié et compressé par le dispositif de compression d'amplitude 4 qui délivrera donc sur la borne de sortie 11 un signal de parole d'amplitude constante.

Ce dispositif délivre des signaux de parole d'amplitude constante en période d'activité vocale, et ne délivre aucun signal (au bruit près de ce compresseur d'amplitude) en dehors de ces périodes.

L'invention n'est pas limitée au mode de réalisation décrit et représenté, en particulier le dispositif peut être réalisé selon les variantes suivantes.

Le dispositif de compression de parole 4 peut être soit une boucle de compression à constante de re-

0010022

sensibilisation rapide qui fait en sorte que les signaux sont amplifiés jusqu'à une valeur crête prédéterminée imposée par la boucle de compression, soit un
amplificateur saturé.

Le dispositif de compression de parole 4 peut être
avantageusement inséré en série entre la ligne à retard
1 et l'interrupteur électronique 3 , ce qui permet
d'éliminer le bruit de ce dispositif en dehors des périodes d'activité vocale.

De tels dispositifs sont notamment utilisables
dans les émetteurs transmettant des signaux de parole.

4

## REVENDICATIONS

1. Dispositif de traitement de signaux vocaux comportant un dispositif de compression d'amplitude des signaux vocaux délivrant des signaux vocaux délivrant des signaux compressés en amplitude, caractérisé en ce qu'il comporte des moyens de détection d'activité vocale pour interrompre la délivrance des signaux compressés en l'absence d'activité vocale dans les signaux vocaux.

2. Dispositif de traitement selon la revendication 1, caractérisé en ce que le détecteur d'activité vocale comporte : un discriminateur parole-bruit et une ligne à retard ayant une entrée commune recevant les signaux vocaux, la ligne à retard retardant les signaux de parole d'une durée $T_1$ égale au temps de propagation de ces signaux à travers le discriminateur parole-bruit; et un interrupteur électronique ayant une entrée couplée à la sortie de la ligne à retard, une entrée de commande couplée à la sortie du discriminateur parole bruit et une sortie couplée à la sortie du dispositif de traitement.

3. Dispositif de traitement selon la revendication 2, caractérisé en ce que le dispositif de compression d'amplitude est inséré en série entre la ligne à retard et l'interrupteur électronique.

4. Dispositif de traitement selon la revendication 2, caractérisé en ce que le dispositif de compression d'amplitude est inséré en série entre l'interrupteur électronique et la sortie du dispositif de traitement.

5. Emetteur caractérisé en ce qu'il comporte au

5

moins un dispositif de traitement selon l'une des revendications précédentes.

0010022

**Office européen des brevets**

# RAPPORT DE RECHERCHE EUROPEENNE

0010022

Numéro de la demande

EP 79 40 0655

| Catégorie | Citation du document avec indication, en cas de besoin, des parties pertinentes | Revendication concernee |
|---|---|---|
| | US - A - 4 071 695 (FLANAGAN)<br>* Figure 1; de colonne 2, ligne 61 à colonne 4, ligne 23; "abstract"; colonne 1, lignes 5-23 *<br><br>-- | 1,2 |
| | GB - A - 1 427 029 (THE CUNARD STEAMSHIP COMP.)<br>* Figures 1 et 2; revendication 2 *<br><br>-- | 1 |
| | DE - A - 2 601 940 (KRAUS)<br>* Figure unique; pages 1 et 2; en entier *<br><br>-- | 1 |
| | IBM TECHNICAL DISCLOSURE BULLETIN, vol. 12, no. 5, octobre 1969, Yorktown Heights,<br>ABBIATE et HUREL :"Audio signal conditioning circuit", page 661.<br>* Article en entier *<br><br>---- | 1 |

## DOCUMENTS CONSIDERES COMME PERTINENTS

**CLASSEMENT DE LA DEMANDE (Int. Cl. 3)**

H 03 G 3/34
H 04 B 1/04

**DOMAINES TECHNIQUES RECHERCHES (Int. Cl. 3)**

H 03 G 3/34
3/26
3/28
H 04 B 1/46
H 03 G 7/00
7/06

**CATEGORIE DES DOCUMENTS CITES**

X: particulièrement pertinent
A: arrière-plan technologique
O: divulgation non-écrite
P: document intercalaire
T: theorie ou principe à la base de l'invention
E· demande faisant interférence
D: document cité dans la demande
L: document cite pour d'autres raisons
&: membre de la même famille. document correspondant

Le present rapport de recherche a ete etabli pour toutes les revendications

| Lieu de la recherche | Date d'acnevement de la recherche | Examinateur |
|---|---|---|
| La Haye | 04-01-1980 | GYSEN |

OEB Form 1503.1 06.78